Europäisches Patentamt

European Patent Office

Office européen des brevets

(19)

(11) Veröffentlichungsnummer: **0 112 399**
**B1**

(12) ## EUROPÄISCHE PATENTSCHRIFT

(45) Veröffentlichungstag der Patentschrift:
**11.03.87**

(51) Int. Cl.⁴: **G 01 B  11/30,** G 01 B  9/02

(21) Anmeldenummer: **82111809.8**

(22) Anmeldetag: **20.12.82**

(54) Interferometrisches Messverfahren für Oberflächen.

(43) Veröffentlichungstag der Anmeldung:
**04.07.84 Patentblatt 84/27**

(45) Bekanntmachung des Hinweises auf die Patenterteilung:
**11.03.87 Patentblatt 87/11**

(84) Benannte Vertragsstaaten:
**DE FR GB IT**

(56) Entgegenhaltungen:
**EP - A - 0 021 148**
**EP - A - 0 045 321**
**DE - A - 2 518 047**
**US - A - 4 188 122**

(73) Patentinhaber: **IBM DEUTSCHLAND GMBH,**
**Pascalstrasse 100, D-7000 Stuttgart 80 (DE)**

(84) Benannte Vertragsstaaten: **DE**

(73) Patentinhaber: **International Business Machines**
**Corporation, Old Orchard Road, Armonk,**
**N.Y. 10504 (US)**

(84) Benannte Vertragsstaaten: **FR GB IT**

(72) Erfinder: **Makosch, Günter, Dipl.-Phys., Stuttgarter**
**Strasse 40, D-7032 Sindelfingen-Maichingen (DE)**
Erfinder: **Schedewie, Franz, Dr., Dipl.-Phys.,**
**Schurwaldstrasse 18, D-7030 Böblingen (DE)**

(74) Vertreter: **Teufel, Fritz, Dipl.-Phys., IBM Deutschland**
**GmbH. Europäische Patentdienste Postfach 265,**
**D-8000 München 22 (DE)**

## Beschreibung

Die Erfindung betrifft ein interferometrisches Messverfahren nach dem Oberbegriff des Anspruchs 1 und Einrichtungen zur Durchführung des Verfahrens nach den Ansprüchen 3 und 4.

Auf vielen Gebieten der Technik und der Wissenschaft muss die Topographie und die Struktur von Oberflächen mit hohem Auflösungsvermögen untersucht und ausgemessen werden; ein besonders wichtiges Anwendungsgebiet stellt dabei die Photolithographie dar, bei der beispielsweise die Lage von Kanten in Masken auf Bruchteile eines Mikrometers genau bestimmt werden muss.

Optische Verfahren und insbesondere Interferenzverfahren eignen sich aufgrund der ihnen innewohnenden hohen Genauigkeit besonders für diese Aufgabe. So wird beispielsweise in der Europäischen Patentanmeldung mit der Veröffentlichungsnummer 21 148 ein interferometrisches Messverfahren angegeben, mit dem die Lage von Kanten oder allgemeiner die Topographie einer Oberfläche untersucht werden kann. Das eigentliche Messsignal wird aus den zur Überlagerung gebrachten und miteinander interferierenden Lichtbündeln durch eine empfindliche Phasenmessmethode gewonnen. Dieses Verfahren ist jedoch nicht zur Untersuchung von Oberflächen geeignet, deren Struktur sich nicht als Höhendifferenz, sondern als Punkte unterschiedlichen Streuvermögens in einer Ebene darstellt. Dasselbe gilt für ein weiteres interferometrisches Messverfahren für Oberflächen, das in der Deutschen Offenlegungsschrift 2 518 047 beschrieben ist.

EP-A 245 321 beschreibt in Figur 4C eine Einrichtung zur optischen Distanzmessung, bei der ein Gitter durch zwei symmetrisch zur optischen Achse eines Abbildungssystems liegende fokussierte Eingangsstrahlenbündel beleuchtet wird. Die Eingangswinkel sind so gewählt, dass die erste Ordnung der am Gitter gebeugten Eingangsstrahlenbündel in Richtung der optischen Achse zurücklaufen, um mit elektro-optischen Methoden auf den Phasenunterschied untersucht zu werden, den sie bei einer Verschiebung des Gitters erleiden. Mit dieser Einrichtung können keine absoluten Abstände zwischen Oberflächenpunkten und der optischen Achse festgestellt werden; ausserdem handelt es sich wie das interferometrische Verfahren der obengenannten EP-A1-21 148 um ein Hellfeldverfahren, bei dem die regulär an der Oberfläche reflektierten bzw. gebeugten Strahlenbündel zur Auswertung gebracht werden. Beide Verfahren eignen sich daher nur für wenig streuende Oberflächen.

Wenn glatte Oberflächen zu untersuchen sind, werden im Stand der Technik keine Phasenmessungen, sondern Intensitätsmessungen des reflektierten oder gestreuten Lichts herangezogen. Wenn dabei Entfernungen oder die absolute Lage von Punkten relativ zur optischen Achse der Untersuchungseinrichtung bestimmt werden sollen, ist bei den im Stand der Technik bekannten Verfahren eine Relativbewegung zwischen dem zur Messung verwendeten Lichtstrahlenbündel und der Oberfläche erforderlich.

Ein weiterer Nachteil bei Intensitätsmessungen ist die beschränkte Genauigkeit bei der Auswertung; einmal hängt der Absolutwert von Intensitätssignalen von einer Vielzahl von im allgemeinen nicht genau bekannten Parametern ab, und zum anderen sind diese Signale oft hochgradig nichtlinear. Wird beispielsweise das beim Überfahren einer Kante reflektierte oder gestreute Licht gemessen, so hat das Ausgangssignal die Gestalt einer Stufe oder, bei einer Dunkelfeldeinrichtung, die eines Impulses. Als genauer Ort der Kante wird üblicherweise ein bestimmter Punkt der so entstandenen Kurve definiert, dessen Lage aber nicht genau oder nur nach weiterer Signalumformung bestimmt werden kann und der nur unter Idealbedingungen mit der tatsächlichen Kantenlage zusammenfällt.

Die vorliegende Erfindung stellt sich daher die Aufgabe, ein Messverfahren und Einrichtungen der eingangs genannten Art anzugeben, mit denen die Lage streuender Punkte auf einer ebenen Oberfläche mit hoher Genauigkeit und ohne Relativbewegung zwischen optischem Messsystem und Oberfläche bestimmt werden kann; ausserdem sollen wenig aufwendige Einrichtungen zur Durchführung des Verfahrens angegeben werden.

Diese Aufgabe wird durch die in den Ansprüchen 1, 3 und 4 gekennzeichnete Erfindung gelöst; Ausgestaltungen der Erfindung sind in den Unteransprüchen gekennzeichnet.

Bei dem hier vorgeschlagenen Messverfahren wird eine streuende Struktur (z.B. die «Kante» zwischen zwei Gebieten mit unterschiedlichen optischen Eigenschaften) durch zwei symmetrisch zur optischen Achse einfallende Lichtbündel beleuchtet. Die von den beiden Eingangsbündeln an der streuenden Struktur erzeugten Streuwellen weisen eine gegenseitige Phasendifferenz auf, die direkt proportional zum Abstand des streuenden Elements von der optischen Achse ist. Mit einer im Stand der Technik bekannten hochempfindlichen Messmethode für die Phasendifferenz zwischen diesen beiden Streuwellen kann dieser Abstand mit sehr hoher Präzision gemessen werden. Das entstehende Ausgangssignal ist streng linear und lässt daher eine genaue Interpolation zu.

Die zur Durchführung des Verfahrens verwendete Einrichtung arbeitet nach dem Prinzip der Dunkelfeldbeleuchtung und wertet nur das an der streuenden Struktur gestreute (nicht aber das direkte reflektierte) Licht für die Phasenmessung aus. Der Aufbau dieser Anordnung ist relativ einfach.

Mit dem hier vorgeschlagenen Verfahren ist ohne Relativbewegung zwischen optischem System und Messoberfläche eine sehr genaue Messung der Absolutlage von streuenden Objektiven relativ zur optischen Achse möglich; der Aufwand für die Durchführung des Verfahrens und die Herstellung der Einrichtung ist gering, der Einfluss von Fehlerquellen klein und die Messgeschwindigkeit hoch. Durch einfache Änderungen einiger optischer Parameter (Öffnungswinkel der verwendeten Bündel etc.) kann die Messanordnung an eine Vielzahl von Messaufgaben angepasst werden. Ergänzt durch einen Regelkreis kann dieses Verfahren auch als Grundlage für eine sehr genaue Positioniereinrichtung, beispielsweise für photolithographische Masken, dienen. Ausführungsbeispiele der Erfindung werden nun anhand von Zeichnungen näher erläutert. Es zeigen:

Fig. 1 die schematische Darstellung zweier auf einer streuenden Oberfläche überlagerter kohärenter ebener Wellen zur Erläuterung des Prinzips der hier vorgeschlagenen Erfindung;

Fig. 2 die schematische Darstellung des Strahlenganges bei fokussierter Beleuchtung der streuenden Oberfläche;

Fig. 3A das Prinzip des Strahlenganges in einer Einrichtung zur Durchführung des Verfahrens nach Fig. 1;

Fign. 3B,C Auf- und Seitenansicht des in Fig. 3A verwendeten Umlenkspiegels für das gestreute Licht;

Fign. 4A,B,C eine andere Ausführungsform der Einrichtung zur Durchführung des Verfahrens nach Fig. 1 und die darin verwendeten komplementären Blenden;

Fign. 5A, B Beispiele für mit der vorliegenden Erfindung erhaltene lineare Ausgangssignale bei Abtastung einer kantenförmigen Struktur.

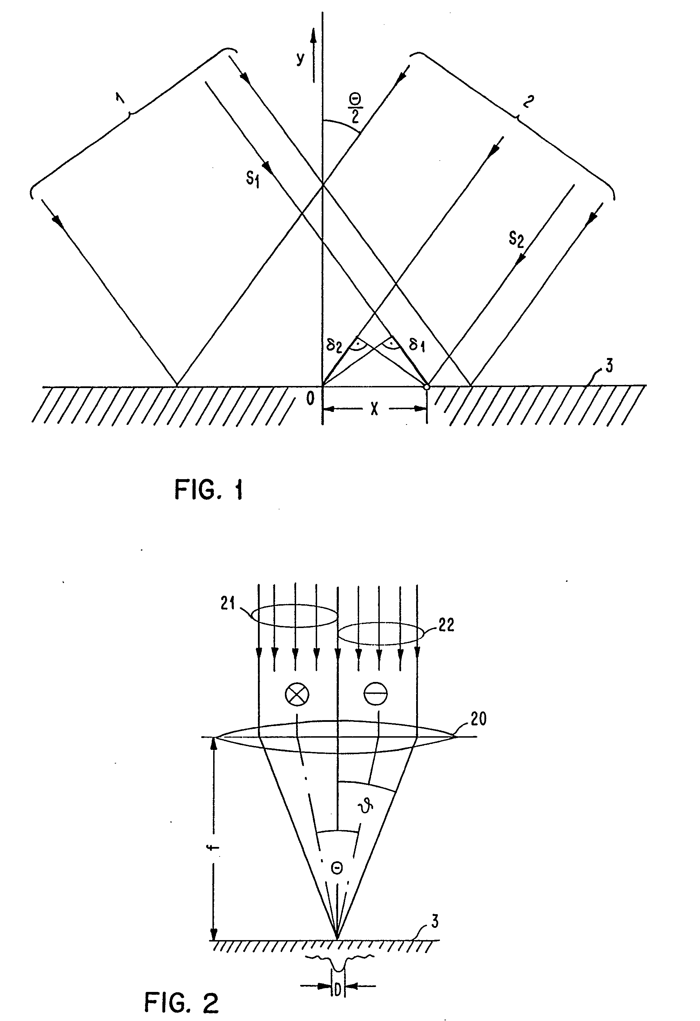

Fig. 1 zeigt zwei ebene, zueinander kohärente Wellen in Strahlenbündeln 1, 2, die symmetrisch zu einer Achse y (der Achse des optischen Systems) unter den Winkeln $\frac{\theta}{2}$ auf die Oberfläche 3 eines Körpers einfallen. Auf der Oberfläche 3 sei im Abstand x von der Achse y ein streuender Punkt vorhanden. Die relative Phasenlage der beiden ebenen Wellen 1, 2 sei so eingestellt, dass sie im Punkt 0 (dem Ursprung des x,y-Koordinatensystems) den Wert 0 habe. Die vom streuenden Punkt x ausgehenden Kugelwellen, die von den beiden Strahlen S1, S2 in den Bündeln 1 und 2 erzeugt werden, weisen, wie aus den in Fig. 1 dargestellten geometrischen Verhältnissen hervorgeht, gegenüber der Phase im Punkt 0 die folgende Phasendifferenz auf:

$$\varrho_1 = -\varrho_2 = \frac{2\pi}{\lambda} \cdot x \cdot \sin \frac{\theta}{2} \qquad (1)$$

(Die Weglängenunterschiede $\delta_1$, $\delta_2$ ergeben sich nämlich nach Fig. 1 zu $x \cdot \sin \frac{\theta}{2}$)

Die gesamte Phasendifferenz der am Punkt x gestreuten Kugelwellen beträgt somit das Doppelte, nämlich

$$\Delta\varrho = \frac{4\pi}{\lambda} \cdot x \cdot \sin \frac{\theta}{2} \qquad (2)$$

Diese Phasendifferenz bleibt in den beiden gestreuten Kugelwellen unabhängig von der Beobachtungsrichtung und vom Beobachtungsort erhalten.

Zur Messung von Phasendifferenzen sind im Stand der Technik hochempfindliche Messverfahren bekannt, deren Auflösung bis zu $\Delta\varrho = 6 \cdot 10^{-3} \pi$ beträgt. Bei einem Überlagerungswinkel der beiden Strahlenbündel von $\theta = 7°$ ergibt sich somit aus Gleichung 2 eine Messempfindlichkeit für die Bestimmung der Lage des Streupunktes x relativ zur Achse y von

$$\Delta x = \frac{\lambda}{4\pi \cdot \sin \frac{\theta}{2}} \cdot \Delta\varrho = 1,5 \cdot 10^{-2} \text{ Micrometer},$$

wenn ein Helium-Neon-Laser mit einer Wellenlänge von $\lambda = 0,63$ Micrometer verwendet wird.

Die Messempfindlichkeit lässt sich noch weiter steigern, wenn der Überlagerungswinkel $\theta$ vergrössert wird.

Ein für die exakte Messung der Phasendifferenz zweier senkrecht zueinander polarisierter Strahlenbündel geeignetes Verfahren ist in der Europäischen Patentanmeldung mit Veröffentlichungsnummer 11 708 beschrieben; die Erzeugung der beiden Strahlenbündel (die hier zur Beleuchtung der Oberfläche dienen sollen) und deren Rekombination erfolgt dort mit doppelbrechenden optischen Elementen. Die Phasendifferenz selbst wird durch elektrooptische Kompensation ermittelt. Äquivalente Messverfahren für Phasendifferenzen sind auch aus modernen dynamischen Interferometern bekannt.

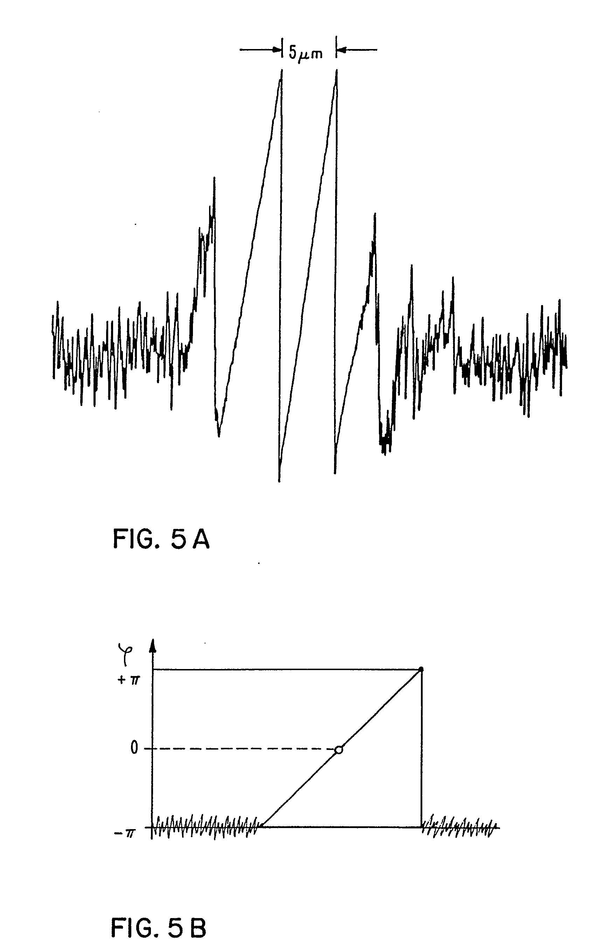

Der Zusammenhang zwischen Phasendifferenz $\Delta\varrho$ und Abstand x von der optischen Achse ist eindeutig, solange der Betrag von x den Wert $\pi$ nicht überschreitet; im anderen Fall ergibt sich eine Sägezahnkurve (Fig. 5B) mit der Periode

$$x = \frac{\lambda}{2 \sin \frac{\theta}{2}} \cdot \qquad (3)$$

Diese Mehrdeutigkeit ist bei manchen Anwendungen störend, so z.B. bei Linienbreiten-Messungen auf Photomasken und Halbleiterscheiben im photolithographischen Prozess. Der eindeutige Wert des Abstands von der optischen Achse lässt sich nur ermitteln, wenn die Sägezahnkurve durch Relativ-Verschiebung der Oberfläche von Anfang an verfolgt wird. Diese unerwünschte Mehrdeutigkeit tritt nicht mehr auf, wenn ein beugungsbegrenzter Strahlengang verwendet wird.

Fig. 2 zeigt einen in der Praxis bevorzugten beugungsbegrenzten Strahlengang, bei dem die zur Überlagerung gebrachten Bündel fokussiert werden und das entstehende Überlagerungsfeld (Brennpunkt) einen Durchmesser D aufweist, der kleiner ist als der eindeutige Bereich von Gleichung 2. Die dazu erforderliche Bedingung wird im Brennpunkt eines fokussierten Laserstrahlenbündels mit dem Öffnungswinkel $\theta$ erreicht, da

dessen Durchmesser D gemäss der Beugungstheorie den Wert

$$D = \frac{\lambda}{2 \cdot \sin \dfrac{\theta}{2}} = \frac{\lambda}{2\,N.A.} \qquad (4)$$

aufweist und damit ein Airy'sches Beugungsscheibchen darstellt (N.A. ist die numerische Apertur des optischen Systems 20).

Bei dem in Fig. 2 dargestellten Strahlenverlauf berühren sich die beiden senkrecht zueinander polarisierten Teilstrahlenbündel 21, 22 längs der optischen Achse und werden mit Öffnungswinkeln $\vartheta$ auf die zu untersuchende Oberfläche 3 fokussiert; die Mittelachsen der beiden Teilstrahlenbündel schliessen dabei den Winkel $\theta$ ein. Die Lichtbündel und damit die Winkel $\vartheta$ sind relativ klein, so dass die im Zusammenhang mit Fig. 1 anhand von ebenen einfallenden Wellen angestellten Überlegungen bezüglich der Phasendifferenz der gestreuten Kugelwellen auch hier ihre Gültigkeit behalten.

Wird in der Anordnung nach Fig. 2 durch symmetrische Strahlführung dafür gesorgt, dass im Zentrum des Brennflecks die Phasendifferenz 0 vorliegt, so misst man an den Rändern des Beugungsscheibchens die Phasendifferenz $-\pi$ bzw. $+\pi$. Eine Kante, die quer durch den Brennpunkt verschoben wird, ändert somit die Phasendifferenz der beiden Streuwellen linear von $-\pi$ bis $+\pi$ und der Messwert $\Delta\varrho = 0$ zeigt mit hoher Präzision die Mittelpunktslage der Kante im Brennpunkt an. Abweichungen von dieser Mittelpunktslage können aufgrund des linearen Signalverlaufs (Fig. 5A) sehr genau bestimmt werden; technisch nachgewiesene Auflösungen liegen bei etwa $3 \cdot 10^{-3}$ D. Da die Phasenmessung sehr schnell durchzuführen ist (0,1 Millisekunde oder weniger) kann durch Mehrfachmessung und Mittelwertbildung ohne weiteres eine noch höhere Genauigkeit erreicht werden.

Die zur optischen Achse symmetrische Anordnung der beiden Strahlenbündel verhindert, dass Unebenheiten und Höhenunterschiede der zu untersuchenden Oberfläche ebenfalls zu einer Phasendifferenz führen und das Messsignal verfälschen, das aufgrund der gestreuten Kugelwellen entsteht.

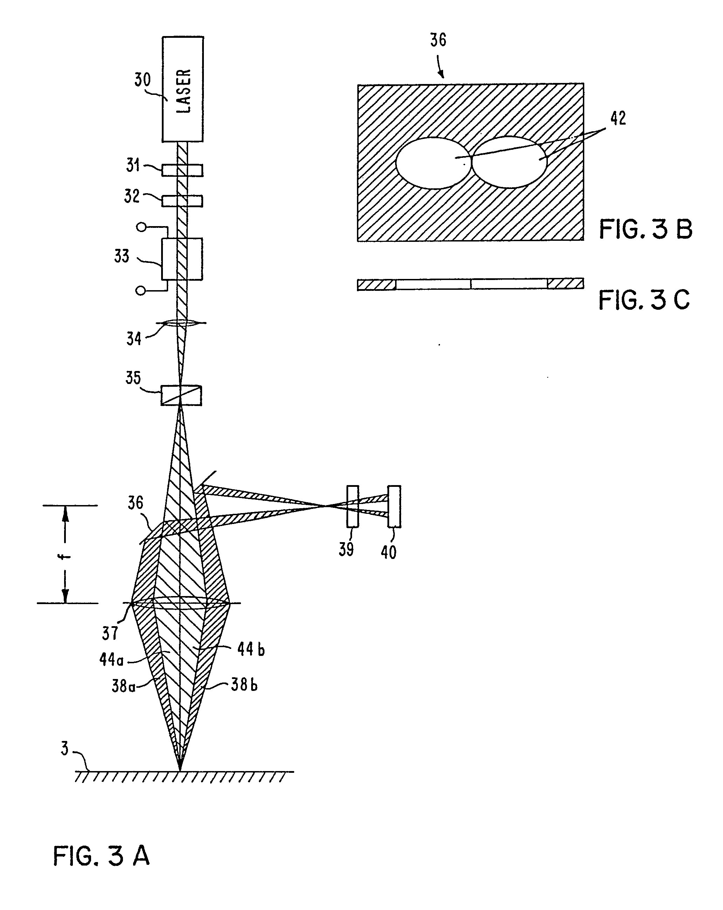

Fig. 3A zeigt in schematischer Weise den Aufbau eines in der Praxis verwendeten Geräts, bei dem die Phasendifferenz nur im gestreuten Licht unter Verwendung der erwähnten elektrooptischen Kompensationsmethode gemessen wird. Die zu untersuchende Oberfläche 3 wird mit dem Licht eines Lasers 30 bestrahlt, der über einer $\lambda/2$-Platte 31, einen Polarisator 32, einen elektrooptischen Phasenmodulator 33 und eine Linse 34 auf ein Wollaston-Prisma 35 fällt, wo er in zwei senkrecht zueinander polarisierte Teilbündel (hell schraffiert) aufgespalten wird, die über eine Spiegelblende 36 und eine Sammellinse 37 (z.B. Mikroskopobjektiv) auf die Oberfläche 3 auftreffen. Das von streuenden Strukturen der Oberfläche 3 ausgehende Licht (stark schraffierte Lichtbündel 38a, 38b) wird durch die Spiegelblende 36 auf einen Polarisator 39 und einen Photodetektor 40 gerichtet und dort entsprechend dem bekannten Verfahren auf seine Phasendifferenz untersucht. Entsprechend den Fig. 3B (Aufsicht) und 3C (Seitenansicht) weist die Spiegelblende 36 elliptische Öffnungen 42 auf, durch die das einfallende Licht sowie das an Oberfläche 3 regulär reflektierte Licht durchtreten können; das Messlicht wird durch die schraffiert dargestellten Spiegelflächen auf den Photodetektor 40 abgelenkt. Die Anordnung nach Fig. 3A ermöglicht also eine Dunkelfeldbeobachtung ohne Störung durch das zur Beleuchtung verwendete Licht. Dieser Effekt wird erreicht, wenn die Spiegelblende 36 in der hinteren Brennebene der Sammellinse 37 liegt, und somit durch Linse 37 und der Oberfläche 3 auf sich selbst abgebildet wird.

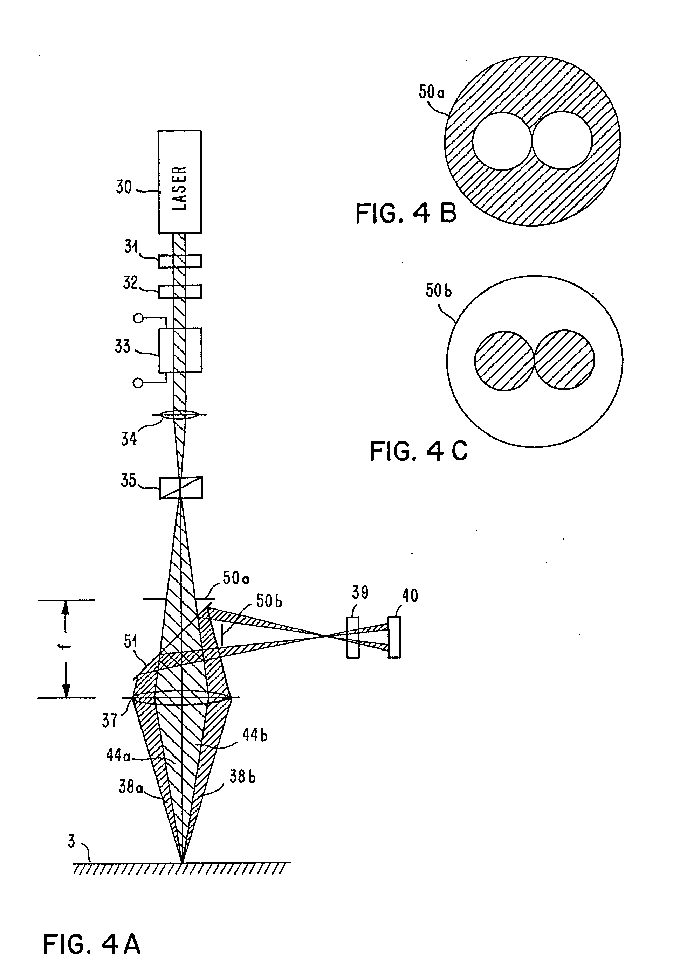

In Fig. 4A ist ein zweiter Weg dargestellt, das an der Oberfläche gestreute Licht allein dem Photodetektor 40 zuzuführen. Zu diesem Zweck werden Komplementärblenden 50A, 50B verwendet, die in den Fig. 4B und 4C vergrössert dargestellt sind; die schraffierten Teile sind jeweils undurchsichtig. Die Blende 50a ist im Beleuchtungsstrahlengang in der hinteren Brennebene der Sammellinse 37 angebracht, die Blende 50b im Auswerte-Strahlengang hinter einem halbdurchlässigen Spiegel 51, der die Spiegelblende 36 von Fig. 4 ersetzt. Bei der Anordnung nach Fig. 5 sind keine elliptischen Öffnungen für die Spiegelblende erforderlich, doch treten am Teilerspiegel Lichtverluste auf.

In den Fig. 5A, 5B sind Messkurven wiedergegeben, wie sie mit den hier beschriebenen Anordnungen erhalten werden. In Fig. 5A wurde ein Messfleck verwendet, der nicht beugungsbegrenzt war, so dass sich eine Sägezahnkurve ergibt, wenn ein streuender Punkt unter der optischen Achse vorbeigeführt wird. Bei beugungsbegrenzten Anordnungen gemäss Gl. 4 ergibt sich ein eindeutiges Messsignal der in Fig. 5B schematisch dargestellten Art, bei der die Phasendifferenz als Funktion des Abstandes von der optischen Achse monoton zunimmt. In diesem Fall kann der absolute Wert des Abstands eines streuenden Elements von der optischen Achse ohne Relativbewegung bestimmt werden; erforderlich ist hierbei nur, dass das streuende Element vom fokussierten Lichtfleck angeschnitten wird.

Zur Linienbreitenmessung oder zur Messung des Abstands zwischen zwei Linien wird die Oberfläche 3 unter dem Brennfleck hinweggeführt; der Abstand zweier Kanten ergibt sich dann aus der Summe der Tischverschiebung und dem interferometrischen Phasenmesssignal.

Das hier vorgestellte Dunkelfeld-Interferenz-Verfahren mit phasenempfindlicher Auswertung ermöglicht es, die absolute Lage von streuenden Strukturen auf ebenen Oberflächen mit sehr hoher Präzision zu messen, ohne dass dazu ein hoher apparativer Aufwand erforderlich ist; diese Vorteile ergeben sich aufgrund der hier für diese Zwecke zum ersten Mal eingesetzten Phasenmessung anstelle der bisher üblichen Intensitätsmessungen. Die Messgenauigkeit für die Ortsbestimmung von streuenden Elementen ist hier um den Faktor 300 gegenüber dem Auflösungsvermögen des optischen Systems gesteigert.

Das hier beschriebene Messverfahren eignet sich für alle Oberflächen, die streuende Elemente aufweisen; dazu gehören Kanten, Rauhigkeiten, Grenzgebiete zwischen optisch verschiedenen Flächen etc. Ein wichtiges Anwendungsgebiet stellen sog. Resistkanten dar, die bei modernen photolithographischen Prozessen auftreten und nur geringe Höhenunterschiede, aber stark streuende Eigenschaften aufweisen.

Eine Weiteranwendung des hier beschriebenen Verfahrens betrifft die Überprüfung der Geradlinigkeit von Kanten und ähnlichen streuenden Gebilden; dazu wird die Oberfläche in Kantenrichtung verschoben, so daß sich bei einer idealen Kante der Abstand zur optischen Achse, der allein die Phasenrichtung bestimmt, nicht ändert.

## Patentansprüche

1. Interferometrisches Messverfahren für Oberflächen, insbesondere zur Messung von Kanten in photolithographischen Strukturen, bei dem zwei symmetrisch zur optischen Achse eines Abbildungssystems liegende und gegeneinander geneigte Strahlenbündel (21, 22) mit zueinander senkrechter Polarisationsrichtung die zu untersuchende Oberfläche (3) beleuchten und der Phasenunterschied des von der Oberfläche ausgehenden Lichtes unterschiedlicher Polarisa-tionsrichtungen bestimmt wird, dadurch gekenn-zeichnet, dass der Phasenunterschied des an der Oberfläche (3) diffus gestreuten Lichtes beider Polarisationsrichtungen gemessen wird.

2. Messverfahren nach Anspruch 1, dadurch gekennzeichnet, dass die beiden zur Beleuchtung der Oberfläche verwendeten Strahlenbündel (21, 22) jeweils die Hälfte einer Sammellinse (20) ausleuchten, die im Abstand ihrer Brennweite von der zu untersuchenden Oberfläche (3) angeordnet ist.

3. Einrichtung zur interferometrischen Messung an Oberflächen, insbesondere zur Messung von Kanten in photolithographischen Strukturen, mit Vorrichtungen zur Erzeugung zweier symmetrisch zur optischen Achse eines Abbildungssystems liegender und gegeneinander geneigter Strahlenbündel (21, 22) mit zueinander senkrechter Polarisationsrichtung zur Beleuchtung der Oberfläche (3) und Vorrichtungen zur Bestimmung des Phasenunterschieds des von der Oberfläche ausgehenden Lichtes unterschiedlicher Polarisationsrichtungen, dadurch gekennzeichnet, dass die beiden zur Beleuchtung der Oberfläche (3) verwendeten Strahlenbündel (44a, 44b; Fig. 3) durch Aufteilung in einem doppelbrechenden optischen Element (35) erzeugt werden, und dass das an der Oberfläche diffus gestreute Licht (38a, 38b) durch einen Spiegel (36) zu einem Photodetektor (40) ausgekoppelt wird, wobei der Spiegel elliptische Öffnungen für die einfallenden und an der Oberfläche (3) direkt reflektierten Strahlenbündel aufweist und in der hinteren Brennebene der Sammellinse (37) angeordnet ist.

4. Einrichtung zur interferometrischen Messung an Oberflächen, insbesondere zur Messung von Kanten in photolithographischen Strukturen, mit Vorrichtungen zur Erzeugung zweier symmetrisch zur optischen Achse eines Abbildungssystems liegender und gegeneinander geneigter Strahlenbündel (21, 22) mit zueinander senkrechter Polarisationsrichtung zur Beleuchtung der Oberfläche (3) und Vorrichtungen zur Bestimmung des Phasenunterschieds des von der Oberfläche ausgehenden Lichtes unterschiedlicher Polarisationsrichtungen, dadurch gekennzeichnet, dass das von der Oberfläche (3) ausgehende Licht über einen Strahlenteiler (51) ausgekoppelt wird und dass die direkt an der Oberfläche reflektierten Strahlenbündel im ausgekoppelten Licht durch eine Stoppblende (50b) ausgefiltert werden, die in der hinteren Brennebene der Sammellinse (37) angeordnet ist und komplementäre Öffnungen zu einer im Beleuchtungsstrahlengang in der hinteren Brennebene der Sammellinse (37) angeordneten Blende (50a) aufweist.

5. Einrichtung nach einem der Ansprüche 3 oder 4, dadurch gekennzeichnet, dass die Bestimmung der Phasendifferenz im gestreuten Licht durch elektrooptische Kompensation erfolgt, wobei im Beleuchtungsstrahlengang ein elektrooptischer Modulator (33) und ein Polarisator (32) angeordnet sind und im Strahlengang des ausgekoppelten gestreuten Lichtes ein Polarisator (39) und ein Photodetektor (40).

## Claims

1. Interferometric measuring method for surfaces, in particular for measuring edges in photolithographic structures, wherein two beams (21, 22), inclined to each other and extending symmetrically to the optical axis of an imaging system, with mutually perpendicular directions of polarization illuminate the surface (3) to be tested, and the phase difference of the light with different direction of polarization emanating from the surface (3) to be tested, and the phase difference of the light with different directions of polarization emanating from the surface is determined, characterized in that the phase difference is measured between the light of two directions of polarization that is diffusely scattered at the sur-face (3).

2. Measuring method according to claim 1, characterized in that the two beams (21, 22) used to illuminate the surface illuminate in each case one half of a convergent lens (20) arranged at the distance of its focal width from the surface (3) to be tested.

3. Device for the interferometric measurement of surfaces, in particular of edges in photolithographic structures, comprising means for generating two beams (21, 22), inclined to each other and extending symmetrically to the optical axis of an imaging system, with mutually perpendicular directions of polarization for illuminating the surface (3), and means for determining the phase difference of the light with different directions of polarization emanating from the surface, characterized in that the two beams (44a, 44b; Fig. 3) used to illuminate the surface (3) are generated by division in a birefringent optical element (35), and that the light (38a, 38b) diffusely scattered at the surface is coupled out by a mirror (36) to a photodetector (40), the mirror having elliptical apertures for the light incident on and directly reflected at the surface (3) and being positioned in the rear focal plane of the convergent lens (37).

4. Device for the interferometric measurement of surfaces, in particular of edges in photolithographic structures, comprising means for generating beams (21, 22), inclined to each other and extending symmetrically to the optical axis of an imaging system, with mutually perpendicular directions of polarization for illuminating the surface (3), and means for determining the phase difference of the light with different directions of polarization emanating from the surface, characterized in that the light emanating from the surface (3) is coupled out through a beam divider (51), and that the beams in the coupled out light directly reflected at the surface are filtered out through a stopper diaphragm (50b) positioned in the rear focal plane of the convergent lens (37) and having complementary apertures to a diaphragm (50a) positioned in the illuminating beam path in the rear focal plane of the convergent lens (37).

5. Device according to any one of the claims 3 or 4, characterized in that the phase difference in the scattered light is determined by electrooptical compensation, wherein an electrooptical modulator (33) and a polarizer (32) are positioned in the illuminating beam path and a polarizer (39) and a photodetector (40) are positioned in the coupled out scattered light.

**Revendications**

1. Procédé de mesure interférométrique pour des surfaces, notamment pour la mesure d'arêtes dans des structures photolithographiques, selon lequel deux faisceaux de rayonnement (21, 22), qui sont disposés symétriquement par rapport à l'axe optique d'un système de formation d'images, sont inclinés l'un par rapport à l'autre et possèdent des directions de polarisation perpendiculaires entre elles, éclairent la surface devant être examinée (3), et on détermine la différence de phase de la lumière partant de la surface avec des directions différentes de polarisation, caractérisé en ce qu'on mesure la différence de phase de la lumière, dispersée de façon diffuse au niveau de la surface (3) et possédant les deux directions de polarisation.

2. Procédé de mesure selon la revendication 1, caractérisé en ce que les deux faisceaux de rayonnement (21, 22), utilisés pour l'éclairement de la surface, éclairent chacun la moitié d'une lentille convergente (20), qui est disposée par rapport à la surface examinée (3) à une distance égale à sa distance focale.

3. Dispositif pour effectuer une mesure interférométrique sur des surfaces, notamment pour la mesure d'arêtes présentes dans des structures pholithographiques, et comportant des dispositifs pour produire deux faisceaux de rayonnement (21, 22), disposés symétriquement par rapport à l'axe optique d'un système de formation d'images, inclinés l'un par rapport à l'autre et possédant des directions de polarisation perpendiculaires entre elles, pour éclairer la surface (3) et des dispositifs pour déterminer la différence de phase de la lumière partant de la surface et possédant des directions de polarisation différentes, caractérisé en ce que les deux faisceaux de rayonnement (44a, 44b; figure 3), utilisés pour éclairer la surface (3) sont produits par subdivision dans un élément optique biréfringent (35), et que la lumière (38a, 38b) qui est diffusée au niveau de la surface, est extraite par découplage au moyen d'un miroir (36) en étant dirigée vers un photodétecteur (40), le miroir comportant des ouvertures elliptiques pour les faisceaux de rayonnement incidents, qui sont réfléchis directement dans le plan focal postérieur de la lentille convergente (37).

4. Dispositif pour effectuer une mesure interférométrique au niveau de surfaces, notamment pour la mesure d'arêtes présentes dans des structures photolithographiques, comportant des dispositifs pour produire deux faisceaux de rayonnement (21, 22) disposés symétriquement par rapport à l'axe optique d'un système de formation d'images, inclinés l'un par rapport à l'autre et possédant des directions de polarisation perpendiculaires entre elles, pour éclairer la surface (3) et des dispositifs pour déterminer la différence de phase de la lumière partant de la surface et possédant des directions de polarisation différentes, caractérisé en ce que la lumière partant de la surface (3) est extraite par découplage par l'intermédiaire d'un diviseur de faisceau (51) et que les faisceaux de rayonnement réfléchis directement au niveau de la surface sont éliminés par filtrage, dans la lumière extraite par découplage, au moyen d'un diagramme d'arrêt (50b), qui est disposé dans le plan focal postérieur de la lentille convergente (37) et comporte des ouvertures complémentaires de celles d'un diagramme (50a) disposé, sur le trajet de rayonnement d'éclairement, dans le plan focal postérieur de la lentille convergente (37).

5. Dispositif selon l'une des revendications 3 ou 4, caractérisé en ce que la détermination de la différence de phase dans la lumière diffusé est réalisée au moyen d'une compensation électro-optique, auquel cas un modulateur électro-optique (33) et un polariseur (32) sont disposés sur le trajet du rayonnement d'éclairement et un polariseur (39) et un photodétecteur (40) sont disposés à l'entrée du rayonnement formé par la lumière diffusée, extraite par découplage.

FIG. 1

FIG. 2

FIG. 3 A

FIG. 3 B

FIG. 3 C

FIG. 4 B

FIG. 4 C

FIG. 4 A

0 112 399

11

FIG. 5 A

FIG. 5 B